# EUROPEAN PATENT APPLICATION

(11) **EP 2 317 489 A1**
(43) Date of publication of application: **04.05.2011**
(21) Application number: 09174760.0
(22) Date of filing: 02.11.2009
(51) Int. Cl.: G09B 23/28, H01L 51/50, A63H 3/00

(54) **Artificial skin and patient simulator comprising the artificial skin**

(71) Applicant: Technische Universiteit Eindhoven, 5612 AZ Eindhoven (NL)
(72) Inventor: Delbressine, Franciscus Leonardus Marie, 6463 GL, Kerkrade (NL); Van Den Boomen, Gerardus Johannes Antonius, 5751 MV, Deurne (NL); Feijs, Laurentius Michiel Gerardus, 5663 EZ, Geldrop (NL)
(74) Representative: DeltaPatents B.V.

(57) **Abstract**

The invention relates to an artificial skin (10, 12, 14), and relates to a patient simulator (100) comprising the artificial skin. The artificial skin is a layered structure comprising a translucent cover layer (20) configured for imitating human or animal skin, and comprising a light emitting layer (30, 32, 34) being configured for emitting light from a surface of the light emitting layer through the translucent cover layer for adapting the color of the artificial skin into a predefined color of the artificial skin, a lateral dimension of the light emitting layer being configured to closely imitate a real-life coloring of the artificial skin. The light emitting layer may, for example, extend substantially parallel to at least a part of the translucent cover layer for substantially following an outer topography of the artificial skin. The light emitting layer may also comprises a lateral shape (L, Lx, Ly) substantially corresponding to a shape of an area of the human or animal skin being changeable to the predefined color.

The effect of the artificial skin according to the invention is that a real-life coloring effect is achieved in the artificial skin which provides excellent training quality.

## Description

### FIELD OF THE INVENTION:

The invention relates to an artificial skin for imitating human or animal skin coloring.

The invention further relates to a patient simulator comprising the artificial skin.

### BACKGROUND OF THE INVENTION:

Artificial skin for imitating human or animal skin is known per se. This is, inter alia, known from the toy-industry in which baby-dolls, for example, have a look and feel substantially corresponding with real babies. Also for toy animals the skin and fur of the animal is imitated to some degree such that the skin and fur of the toy animal resembles the skin and fur of the animal which is imitated.

Also in the field of patient simulators, artificial skin is used to optimize the training session when using the patient simulator by optimizing the touch and feel of the skin of the patient simulator. When training medical personnel, patient simulators are used more and more. Such patient simulators simulate (part of) the body of the patient such that specific medical treatment may be practiced. Especially in the field of neonatology the patient simulator simulates, for example, a (part of) a neonatal which may be used, for example, together with a patient simulator simulating (part of) the mother to train the medical personnel for situations which may occur during childbirth.

A complication occurring frequently and which often requires acute action of the medical personnel is lack of oxygen of the neonatal. This may occur due to complications during childbirth or due to other complications of the neonatal. The patient simulator used in training the medical personnel for acute complications during childbirth should be able to provide external signals indicating the lack of oxygen and possible external signals to indicate that the medical personnel working with the patient simulator are acting correctly to the correctly identified lack of oxygen after which an improvement to the situation of the neonatal should also be visible. So it is important that the external signs of, for example, lack of oxygen are visible in the patient simulator.

The US patent application US 2008/0138778 discloses a newborn simulator for teaching patient care. The newborn simulator includes a body comprising one or more simulated body portions sized to simulate a newborn baby and a head portion movably connected to a portion of the body. A simulated heart is positioned at least partially within the body along with a pair of simulated lungs. The simulator is operable without physical connection to an external device to provide the simulated hart beat and respiratory pattern. In one embodiment, the hands and feet as well as the face and upper torso change color based upon proper oxygenation or an oxygen deficit. As oxygenation decreases, the extremities change color first, followed by the face and upper torso. Such change is reversible as oxygenation is improved. The coloration is achieved using blue thermochromatic dye applied at the extremities and face and upper torso. The thermochromatic dye is activated via resistance heaters which are connected under the skin to provide heat energy sufficient to vary and control the color of the extremities and the face and upper torso of the newborn simulator.

A drawback of the known newborn simulator is that external factors which may surround the newborn simulator may influence the local coloring of the skin causing incorrect simulation situations.

### SUMMARY OF THE INVENTION:

It is an object of the invention to provide artificial skin in which the color of the skin may be altered while reducing the influence of external factors which may be present in the local surroundings.

According to a first aspect of the invention the object is achieved with an artificial skin configured for adapting a color of the artificial skin to closely imitate a real-life coloring of the artificial skin. The artificial skin according to the invention is a layered structure comprising a translucent cover layer configured for imitating human or animal skin, and comprising a light emitting layer being configured for emitting light from a surface of the light emitting layer through the translucent cover layer for adapting the color of the artificial skin into a predefined color of the artificial skin. A lateral dimension of the light emitting layer is configured to closely imitate a real-life coloring of the artificial skin.

Within the context of this invention a patient simulator comprises both the physical object which resembles (part of) the patient's body, including any devices and systems which are connected to or working together with the physical object to contribute to the simulating of the patient. A real life coloring comprising a coloring which closely imitates the actual coloring as it takes place in the human or animal skin. To achieve a coloring which resembles the real-life coloring via a light emitting layer, the area from which the light is emitted should have dimensions resembling dimensions of the extremities such as fingertips and toes of a neonatal which have a dimension of approximately 3 millimeter by 3 millimeter. Furthermore, the gradient between the colored artificial skin and the surrounding skin should be relatively gradual both in color and in intensity. For this reason a light emitting layer having a specific lateral dimension is required to achieve a coloring of the artificial skin which closely resembles the real-life coloring of the human or animal skin. Individual point-light sources such as light emitting diodes for generating a coloring of the artificial skin should be avoided because such point-light sources typically have a too strong gradient to achieve a real-life coloring effect.

The effect of the artificial skin according to the invention is that the coloring is achieved by using a light emitting layer in which the light is emitted from the surface of the light emitting layer to generate a real-life coloring effect. The lateral dimensions may, for example, resemble the real-life area or may, for example, be close to the real-life area which is required to be colored to be able to simulate external signs in a patient simulator to closely simulate a real-life situation. By choosing the lateral dimensions to be similar to the real-life area which changes color in the real-life situation, a relatively low intensity may be used to be emitted from the light emitting layer across the light emitting layer to generate the coloring of the artificial skin. Consequently low intensity gradients will occur which also contribute to the quality of the simulation. Furthermore, by using a light emitting layer for generating the coloring effect, external factors which surround the patient simulator comprising the artificial skin may not have such a strong influence on the external signs which are to be provided to the trainee to obtain his or her response to the tested situation. In the known patient simulator the coloration to simulate oxygen deficit is achieved via the use of thermochromatic paint. Such thermochromatic paint may be applied to the artificial skin or may be mixed in the artificial skin at the location where the coloring of the artificial skin is required. To activate the thermochromatic paint, local resistance heaters are applied underneath the skin to control the local temperature and consequently to control the local color. Such thermochromatic paint does not emit light, but reflects ambient light. The color which is reflected by the thermochromatic paint provides the perceived color of the thermochromatic paint which may be changed by the temperature of the thermochromatic paint. However, such resistance heaters require relatively high power to operate which is not preferred in patient simulators, especially when using the patient simulator to simulate a neonatal which should be handled as a real-life neonatal (and so should not have any connection to, for example, an external power supply). Furthermore, the external factors in the surroundings may locally alter the temperature which might trigger the thermochromatic paint and may provide an unwanted and un-logical visual stimulus to the trainee, triggering an unwanted and/or un-logical response from the trainee. Again, in the example in which the patient simulator is a simulator for simulating a newborn baby, the newborn baby has to be kept warm right after birth. This may be done by using an infrared lamp which may trigger the thermochromatic paint in the unwanted visual stimulus, causing the unwanted and/or un-logical response. Using a light emitting layer for generating the coloring of the artificial skin, the light emitting layer operates fully separate from any external factors which achieve the coloring effect. Consequently any influence from external factors on the coloring of the artificial skin is substantially reduced.

Next to the use of thermochromatic paints, the known newborn simulator of US 2008/0138778 also discloses the use of light emitting diodes (further also indicated with LED) to locally change the color. Such LEDs typically are off-the-shelf LEDs which are applied to, for example, the fingertips of the newborn simulator to alter the color of the fingertips in case of, for example, oxygen deficit. Such LED does not provide a real-life simulation of the coloring of the fingertips as it occurs in a real neonatal because the LED is a typical point light source and not a light emitting layer which is part of the artificial skin and which emits light from the surface of the light emitting layer. Due to the point light source characteristic of the LED in the known configuration, relatively high light intensity is required to alter the color over a specific lateral dimension which produces a relatively large gradient which also strongly reduces the real-life effect of the coloring of the fingertips in the known newborn simulator. In the artificial skin according to the invention, the lateral dimension of the light emitting layer is configured to closely imitate a real-life coloring. This lateral dimension includes a dimension which is close to the real-life area which is required to be colored, for example, in the neonatal. Light is emitted substantially across the whole lateral dimension of the light emitting layer which provides a gradual coloring and enables a substantial uniform coloring of the whole lateral dimension. This enables to closely imitate a real-life coloring which is substantially independent of external factors surrounding the artificial skin.

A further advantage of the artificial skin according to the invention is that such light emitting layers typically require less power compared to the known combination of thermochromatic paint with resistance heaters. To minimize any external heat-related influences in the thermochromatic paint, the resistance heaters may be switched on to provide a coloring of the thermochromatic paint which is perceived as a healthy situation. Placing the newborn simulator under an infrared lamp would not trigger the thermochromatic paint to change to a bluish color which would lead to a false trigger to the trainee. The resistance heaters typically have a relatively high power consumption, and when the resistance heaters are required to be switched on continuously to provide a healthy appearance, the power consumption of the newborn simulator is very high, requiring a relatively bulky (and typically heavy) power supply. In the artificial skin according to the invention, the light emitting layer is only switched on when a change of color of the translucent cover layer is required. Furthermore, the light emitting layer may be constructed in different ways which each typically require only little power. This results in a power-efficient solution which may relatively easily be integrated in relatively small patient simulators such as a patient simulator of a neonatal.

In an embodiment of the artificial skin, the light emitting layer extends substantially parallel to at least a part of the translucent cover layer (20) for substantially following an outer topography of the artificial skin. This embodiment has as an advantage that the real-life impression is further improved in that due to the parallel arrangement of the light emitting layer and the translucent cover layer, the outer topography or outer shape and height differences of the artificial skin is closely followed, which further reduces unwanted intensity variations in the skin. Also in real-life, the coloring of the skin - especially in the case of oxygen deficit - is caused by the changing of the color of the blood which is present in the skin. This blood is typically evenly distributed in the skin and as such also follows the outer topography or shape and form of the outer skin layer. Consequently, the local coloring of the skin in real-life closely follows the outer shape and form of the outer skin layer. By having the light emitting layer arranged parallel to the translucent layer and to have the light emitting layer to follow the outer topography of the artificial skin, the real-life resemblance of the coloring in the artificial skin according to the invention is further enhanced.

In an embodiment of the artificial skin, the light emitting layer comprises a lateral shape substantially corresponding to a shape of an area of the human or animal skin being changeable to the predefined color. For example, when oxygen deficit occurs in a neonatal, the fingertips will change color after which part of the facial-area and chest-area will change color. Especially in the facial-area the changing of color due to oxygen deficit occurs evenly around the mouth. To mimic this local changing of the color in the patient simulator according to the invention, the light emitting layer comprises a lateral shape which resembles the shape of the area which changes color- in our example, the area around the mouth of the neonatal. Consequently, a substantial even coloring may be obtained around the mouth of the patient simulator in which the lateral shape corresponds to the shape observed in real-life coloring of the neonatal. This further enhances the real-life experience and contributes to the quality of the training of the medical personnel.

In an embodiment of the artificial skin, the light emitting layer comprises an electroluminescent sheet. Electroluminescent sheets which are commercially available, for example, from Seikosha (product code, for example, SKP-Y16W) represent thin flexible sheets of light emitting layer which may be applied parallel to at least part of the translucent cover layer to generate the artificial skin. These flexible ultra-thin electroluminescent sheets (thickness of minimal 0,17 millimeter) may be applied such that they follow the outer shape of the patient simulator to improve the real-life resemblance of the coloring achieved in the artificial skin applied to a patient simulator. Next to relatively low power consumption, these electroluminescent sheets emit light substantially across the whole surface of the electroluminescent sheet. These electroluminescent sheets may also be applied in different lateral shapes to mimic the area of the human or animal skin which is required to change color. Consequently, a low-power light emitting layer may be generated which may be beneficially used to mimic the real-life coloring effect in the artificial skin.

In an embodiment of the artificial skin, the light emitting layer comprises an organic light emitting diode device. Also organic light emitting diode device constitute a light emitting layer which may be produced in lateral dimensions useful to closely imitate a real-life coloring of the artificial skin.

In an embodiment of the artificial skin, the light emitting layer comprises a light-guide being configured for receiving light from a light source and for guiding the light in a direction substantially parallel to the light emitting layer, the light guide further comprises light extraction means for extracting light from the light-guide towards the translucent cover layer. Also light-guides may be produced very thin which may still efficiently guide light of, for example, a light emitting diode or of a laser diode in a direction substantially parallel to the translucent cover layer. At the location where coloring is required, light extraction means may be present. In such locations, the extent and density of the light extraction means may be chosen to achieve a lateral shape and lateral dimension which corresponds to the lateral shape and dimension of the area which is required to change color. The light source typically is arranged remote from the location where the light is to be extracted, which simplifies the construction of the patient simulator in that the light guide may be applied parallel to the translucent cover layer while the light source may be applied remote from the artificial skin at a region inside the patient simulator where there is sufficient space. Furthermore, the use of a light-guide as light emitting layer enables the use of multiple different light sources which each emit a different color into the light-guide. By controlling the contribution of each of the multiple different light sources, the color-change due to the emission of the light from the light emitting layer may be altered. For example, the light-guide may comprise a first light source emitting light having a specific color blue which imitates, when emitted through the translucent cover layer a situation of oxygen deficit. The light-guide may comprise a second light source emitting light having a different color compared to the first light source to simulate a different patient situation. A controller may be configured to adapt the intensity of each of the two light sources to obtain the locally required coloring of the artificial skin.

A further benefit when using a light-guide is that additional luminescent materials may be applied to the light guide - even locally - to alter the coloring locally to more closely match the required coloring of the artificial skin, or to provide a different coloring at a first location in the artificial skin and a second coloring, different or slightly different from the first coloring at a second location in the artificial skin. A single light-guide may be used to distribute the light of the light source throughout the light-guide. By locally applying luminescent materials, the color of the light emitted at a specific area may be different compared to the color of the light emitted around a further area while only a single light source is used. Alternatively even local variations may be generated. For example, internal injuries may be visible from the outside by areas having a varying color - more deep blue in the center and more yellow at the edge of an internal injury. By applying a varying luminescent material, such an internal injury may be simulated at a location on the artificial skin such that the trainee is provided with a specific trigger which closely resemblances to what will be observed in a real-life situation.

In an embodiment of the artificial skin in which the light emitting layer comprises the electroluminescent sheet, the electroluminescent sheet is constituted by a first electroluminescent material emitting light of a first color and is constituted by a second electroluminescent material emitting light of a second color different from the first color. When the controller is configured for controlling the light emission from the first electroluminescent material independent from the light emission of the second electroluminescent material, different color effects may be generated in the artificial skin. The first electroluminescent material may, for example, be arranged between the second electroluminescent material and the translucent cover layer. In such an embodiment the first electroluminescent material may, for example, be at least partially transparent to the light emitted by the second electroluminescent material to allow the light of the second electroluminescent material to be emitted from the artificial skin via the translucent cover layer. The first electroluminescent material may also be applied in a layer comprising a distribution of holes through which light of the second electroluminescent material may be emitted toward the translucent cover layer. In such embodiments, the light of the first electroluminescent material and of the second electroluminescent material may be used at a single location in the artificial skin.

Alternatively, the first electroluminescent material and the second electroluminescent material may be interleaved to form the electroluminescent sheet. In such an embodiment the individual dimensions of separate areas of the first electroluminescent material and the second electroluminescent material in the interleaved sheet is preferably such that the separate areas are not visible through the translucent cover layer.

In an embodiment of the artificial skin, the artificial skin comprises a controller configured for independently control the first electroluminescent material and the second electroluminescent material. As indicated before, this independent controlling of the first electroluminescent material and the second electroluminescent material enables a broad range of color changes to be locally applied.

In an embodiment of the artificial skin in which the light emitting layer comprises the light-guide, the light-guide is constituted by an arrangement of a plurality of light fibers, each light fiber comprises light extraction means. The plurality of light fibers may, for example, be woven to form a plaiting-layer or interweaving-layer of light fibers to form the light-emitting layer. In such an arrangement it may be relatively easy to produce a maze of different colors of light which may contribute to the local coloring at the location in the artificial skin which requires coloring. Using different light sources which may be connected to a plurality of light fibers, an even emission of light of each of the different light sources may be obtained while still having a relatively thin and flexible light guide which may relatively easily be applied as a light emitting layer in the artificial skin.

In an embodiment of the artificial skin in which the light emitting layer comprises the light-guide, a local density and/or distribution of the light extraction means is configured for generating a lateral distribution of the extracted light across a part of the translucent cover layer. This local density and/or distribution may, for example, resemble the lateral dimension and/or shape and/or intensity-distribution of the area which in real-life changes color.

In an embodiment of the artificial skin, the artificial skin further comprises a sensor and a controller, the sensor being configured for sensing an ambient condition, and the controller being configured for adapting the emission of light from the light emitting layer depending on the sensed ambient condition. The ambient condition may, for example, comprise an ambient illumination condition in which the sensor provides information regarding the ambient illumination condition and in which the controller is configured for adapting the emission of light from the light emitting layer in response to the sensed ambient illumination condition. The ambient illumination condition comprises an intensity of the ambient light and/or a color of the ambient light. As indicated before, the emission of the light from the light emitting layer contributes to the light reflected from the translucent cover layer to generate a perceived color of the artificial skin. When the intensity and/or color of the ambient light is altered, the intensity and/or color of the light emitted by the light emitting layer may not provide the coloring of the artificial skin which imitates the real-life coloring of the artificial skin. This may be simply illustrated by placing the neonatal in a dark room in which the skin-coloring is - of course - not visible. If the light emitting layer would still continue to emit light to imitate the light coloring, such patient simulator would emit light, which of course does not present a real-life situation. When trying to train medical personnel in observing color variations in various illumination situations, the information of the sensor may be used to adapt the coloring of the artificial skin such that it resembles the required real-life coloring - also in changed illumination conditions. Also when the intensity of the ambient light changes, the intensity of the light emitted by the light emitting layer may need changing to ensure that the coloring of the artificial skin still corresponds to the required coloring which corresponds to the real-life situation. The required response of the light emitting layer may be coded in the controller via an algorithm or may be coded in the controller via a look-up-table which provides drive-signals to apply to the light emitting layer by the controller in response to received measurement signals from the sensor.

Alternatively, the ambient condition may, for example, comprise an ambient temperature condition in which the controller is configured for adapting the emission of light from the light emitting layer in response to the sensed ambient temperature condition. Ambient temperature may generate a response in the skin by a specific coloring. When the ambient temperature is relatively low, the skin is relatively pale due to the reduction of the blood circulating through the upper region of the skin. When the ambient temperature is relatively high, the skin has a relatively red appearance due to the increase of blood circulating through the upper region of the skin in an attempt to reduce the body temperature. This behavior may be mimicked in the artificial skin in which the artificial skin comprises a temperature sensor for sensing the ambient temperature. Again, the controller may comprise an algorithm via which the required signal to the light emitting layer may be controlled to achieve the required coloring. Alternatively, a look-up-table may be used to translate the received sensor signal into a drive signal for driving the light emitting layer.

In an embodiment of the artificial skin, the artificial skin further comprises a diffuser layer arranged between the translucent cover layer and the light emitting layer. Especially when the light emitting layer comprises a maze of different light emitting materials, such diffuser layer may distribute the emitted light evenly across a part of the artificial skin such that the individual areas of different light emitting materials are not visible from the outside.

In an embodiment of the artificial skin, the translucent cover layer is configured for having a color being perceived as healthy when irradiated with ambient light, and wherein a color of the light emitted by the light emitting layer is configured for generating a predefined color of the artificial skin after transmission through the translucent cover layer. The ambient light used in this situation is ambient light which is typically used to illuminate a room, for example, in a hospital or at a doctor. The ambient light in the current embodiment does not include special lighting situations which may be present in a specific situation which may fill part of the surroundings around the artificial skin and which may cause the color of the artificial skin to deviate from a healthy appearance. Such special lighting situations include, for example, the use of special light-sources such as so called black-lights which may be used to identify specific health-conditions but which do not typically occur as illumination in a typical room. This embodiment has as its benefit that in a healthy situation, no additional light has to be emitted from the light emitting layer which minimizes the power consumption of the artificial skin and of the patient simulator comprising the artificial skin.

In an embodiment of the artificial skin in which the light emitting layer comprises the electroluminescent sheet, the artificial skin comprises a power-supply for providing AC-power to the electroluminescent sheet, the power-supply comprising an oscillator stage for receiving a DC input power and for generating a first power signal, and comprising an amplifying stage for receiving the first power signal and for adapting the first power signal for varying an output power signal provided to the electroluminescent sheet. By splitting the oscillator stage in the power-supply from the amplifying stage, a power-supply is provided which may provide AC-power over a relatively large range while remaining substantially stable within this range. Typically the output power signal is transformed to higher voltages via a transformer stage. A further advantage of this splitting of the oscillator stage and the amplifying stage is that a sensing signal received from the sensor for sensing an ambient condition may be used to control the intensity of the light emitted from the light emitting layer. The sensing signal may directly be used as control-signal for controlling the amplifying stage to control the output power signal, and consequently the intensity of the light emitted from the electroluminescent sheet. An additional operational amplifier for increasing the sensing signal may be present before the sensing signal is used as control-signal.

According to a second aspect of the invention the object is achieved with a patient simulator comprising the artificial skin according to the invention.

### BRIEF DESCRIPTION OF THE DRAWINGS:

These and other aspects of the invention are apparent from and will be elucidated with reference to the embodiments described hereinafter.

In the drawings:
Figs. 1A to 1C are schematic cross-sectional representations of different embodiments of the artificial skin according to the invention,
Figs. 2A to 2C are schematic cross-sectional representations of embodiments of the artificial skin according to the invention in which different electroluminescent materials are used, each emitting a different color,
Figs 3A and 3B are schematic top-views of different embodiments of the light emitting layer for the artificial skin according to the invention,
Figs, 4A and 4B are schematic electronic circuits which are used to provide regulated power to the electroluminescent sheet and to amplify the sensing signal from the sensor, respectively, and
Fig. 5 is a schematic representation of a patient simulator comprising the artificial skin according to the invention.

The figures are purely diagrammatic and not drawn to scale. Particularly for clarity, some dimensions are exaggerated strongly. Similar components in the figures are denoted by the same reference numerals as much as possible.

### DETAILED DESCRIPTION OF THE EMBODIMENTS:

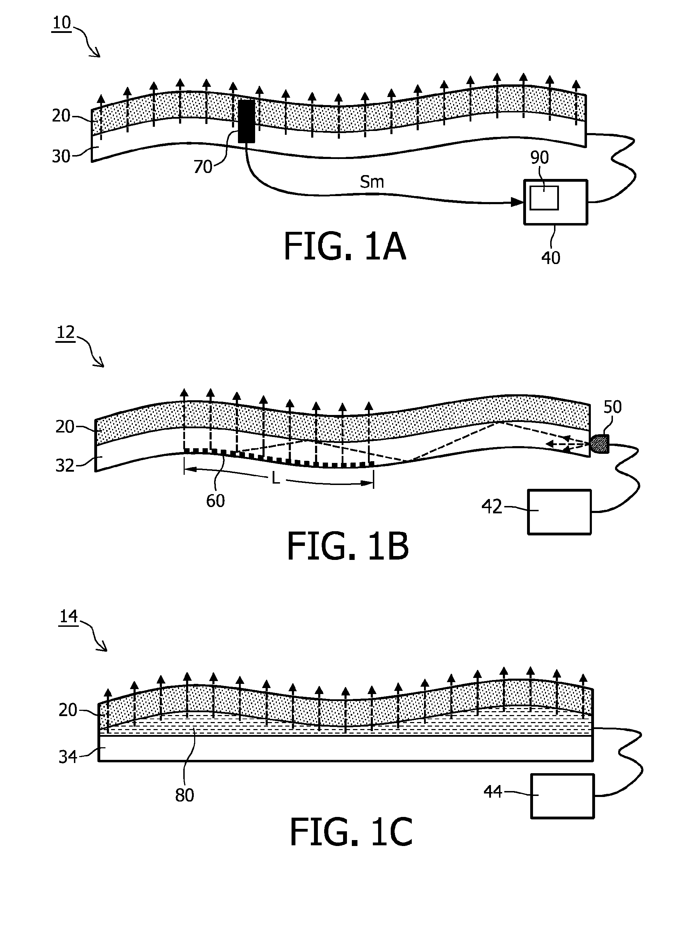

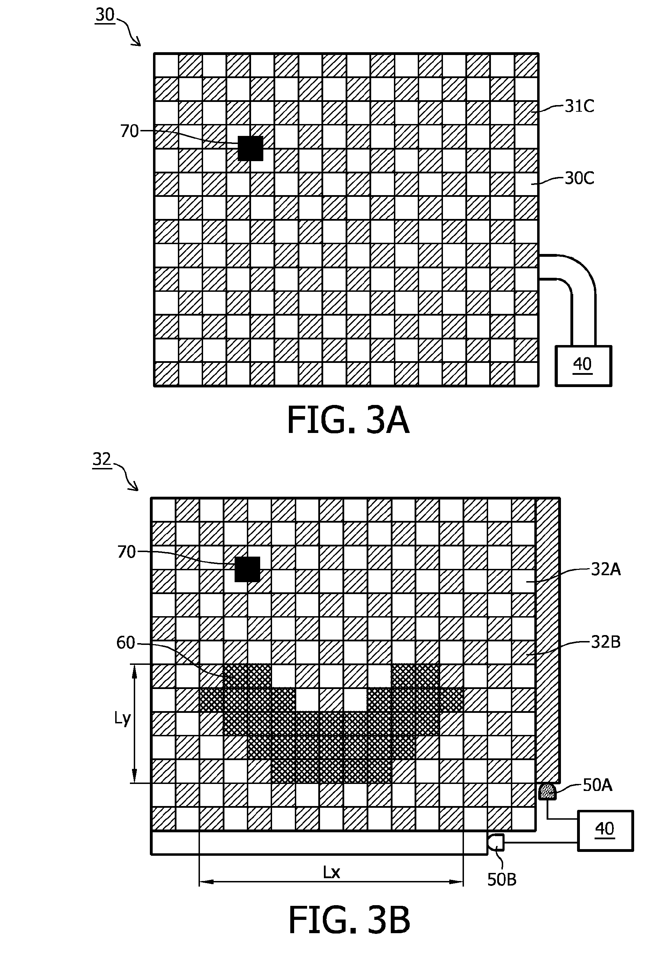

Figs. 1A to 1C are schematic cross-sectional representations of different embodiments of the artificial skin 10, 12, 14 according to the invention. The artificial skin 10, 12, 14 according to the invention is a layered structure comprising a translucent cover layer 20 configured for imitating human or animal skin, and comprising a light emitting layer 30, 32, 34 which is configured for emitting light from a surface of the light emitting layer 30, 32, 34 through the translucent cover layer 20 for adapting the color of the artificial skin 10, 12, 14. This effect of emission of light from the surface is indicated in the examples of Figs. 1A to 1C using the dashed arrows emanating from the light emitting layer 30, 32, 34. The light emitting layer 30, 32, 34 has lateral dimensions to enable a more close imitation of a real-life coloring of the artificial skin 10, 12, 14. To achieve a coloring which resembles the real-life coloring via the light emitting layer 30, 32, 34, the area from which the light is emitted should have dimensions Lx, Ly (see Fig. 3B) resembling dimensions of the extremities such as fingertips (not shown) and toes (not shown) of a neonatal which have a dimension of approximately 3 millimeter by 3 millimeter. Of course, if the area which is to be colored increases, the area from which the light is emitted should also increase. Furthermore, the coloring of the artificial skin should preferably comprise a gradient between the colored artificial skin and the surrounding skin which should be relatively gradual both in color and in intensity. Also for this reason the lateral dimensions of the light emitting layer 30, 32, 34 should be similar to the lateral dimensions of the area which is to be colored.

The coloring of the artificial skin 10, 12, 14 according to the invention is achieved by using the light emitting layer 30, 32, 34 from which the light is emitted. By choosing the lateral dimensions to be similar to the real-life area which changes color in the real-life situation, a relatively low intensity may be used to be emitted from the light emitting layer 30, 32, 34 across the light emitting layer 30, 32, 34 to generate the coloring of the artificial skin 10, 12, 14. Consequently low intensity gradients will occur which also contribute to the quality of the simulation.

The color perceived by a human watching the translucent cover layer 20 is determined by the reflection of ambient light which impinges on the translucent cover layer 20 and of which part of the impinging light is reflected. This reflected light determines the perceived color of the translucent cover layer 20. In a preferred embodiment the color of the translucent cover layer 20 resembles a situation in the artificial skin 10, 12, 14 which is perceived as healthy when irradiated with ambient light. The light emitted by the light emitting layer 30, 32, 34 should add light of a specific color to the reflected light from the translucent cover layer 20 such that the overall perceived color of the artificial skin 10, 12, 14 resembles a real-life skin coloring. As such, the intensities of the light emitted by the light emitting layer 30, 32, 34 are preferably relatively low and preferably do not exceed the intensity of the ambient light surrounding the artificial skin 10, 12, 14. When the color of the translucent cover layer 20 corresponds to a perceived healthy situation of the artificial skin 10, 12, 14, no additional light is to be added to the reflected light from the translucent cover layer 20 in a normal, healthy situation. As such, only in case a specific coloring is require of the artificial skin 10, 12, 14 the light emitting layer 30, 32, 34 is switched on which results in relatively low power consumption of the artificial skin 10, 12, 14 according to the invention.

The artificial skin 10, 12, 14according to the invention comprises a controller 40, 42, 44 for controlling the emission of light (color and/or intensity) from the light emitting layer 30, 32, 34. Furthermore, the controller 40, 42, 44 may be configured for providing power to the artificial skin 10, 12, 14. The controller 40, 42, 44 may, for example, comprise a power supply 90 for supplying the power to the light emitting layer 30, 34 or to a light source 50 which emits light into a light-guide 32 constituting the light emitting layer 32.

In a preferred embodiment, both the light emitting layer 30, 32 and the translucent cover layer 20 are flexible and may be applied such that the light emitting layer 30, 32 substantially follows the outer topography of the skin. This can be seen in the embodiments shown in Figs. 1A and 1 B in which the light emitting layer 30, 32 follows the topography of the outer translucent cover layer 20. Having a light emitting layer 30, 32 which follows the topography of the outer translucent cover layer 20 has as an advantage that the real-life impression is further improved. In real-life, the coloring of the skin - especially in the case of oxygen deficit - is caused by the changing of the color of the blood which is present in the skin. This blood is typically evenly distributed in the skin and as such also follows the outer topography or shape and form of the outer skin layer. Consequently, the local coloring of the skin in real-life closely follows the outer shape and form of the outer skin layer. By having the light emitting layer 30, 32 arranged parallel to the translucent layer and to have the light emitting layer 30, 32 to follow the outer topography of the artificial skin 10, 12, the real-life resemblance of the coloring in the artificial skin 10, 12 according to the invention is further enhanced.

The artificial skin 10 may further comprise a sensor 70 for sensing an ambient condition and providing a measurement signal Sm to the controller 40. Such sensor 70 may, for example, be a light sensor 70 which senses the ambient illumination condition impinging on the artificial skin 10. The controller 40 may, for example, be configured for adapting the emission of light from the light emitting layer 30 in response to the sensed ambient illumination condition. The ambient illumination condition comprises, for example, an intensity of the ambient light and/or a color of the ambient light. As indicated before, the emission of the light from the light emitting layer 30 contributes to the light reflected from the translucent cover layer 20 to generate a perceived color of the artificial skin 10. When the intensity and/or color of the ambient light changes, the intensity and/or color of the light emitted by the light emitting layer 30 should also change to ensure that the contribution of the light from the light emitting layer 30 still generates the perceived predefined color of the artificial skin 10.

The required response of the light emitting layer 10 from the measured signal Sm may be coded in the controller 40 via an algorithm (not shown) or may be coded in the controller 40 via a look-up-table (not shown) which provides drive-signals to apply to the light emitting layer 30.

Alternatively, the sensor 70 may, for example, be a temperature sensor 70 which measures an ambient temperature condition in which the controller 40 is configured for adapting the emission of light from the light emitting layer 30 in response to the sensed ambient temperature condition. A change in temperature may generate a completely different response in the skin compared to, for example, oxygen deficit and as such may lead to a completely different coloring of the artificial skin 10. This specific response may be mimicked in the artificial skin 10.

In the embodiment of the artificial skin 10 as shown in Fig. 1A, the artificial skin 10 comprises an electroluminescent sheet 30 applied to the translucent cover layer 20. In the embodiment shown in Fig. 1A, the translucent cover layer 20 is directly applied to the electroluminescent sheet 30. However, also intermediate layers may be present between the translucent cover layer 20 and the electroluminescent sheet 30 without departing from the scope of the invention. Such intermediate layer should at least partially be transmissive to the light emitted by the electroluminescent sheet 30. In the embodiment of the artificial skin 10 as shown in Fig. 1A, the artificial skin 10 also comprises a sensor 70 supplying a measurement signal Sm to the controller 40 for controlling the color and/or intensity of the light emitted by the light emitting layer 30. The controller 40 also comprises a power supply 90 for supplying the electroluminescent sheet 30 with power.

Using electroluminescent sheets 30 as the light emitting layer 30 has as an advantage that the electroluminescent sheets 30 which are currently commercially available are relatively thin and flexible and may be generated in substantially any lateral shape required. Furthermore, they consume relatively little power which may be beneficial when applying such electroluminescent sheets 30 in a neonatal simulator which should preferably be operable without any connection to a controller or power supply.

In the embodiment of the artificial skin 12 as shown in Fig. 1 B the light emitting layer 32 is constituted by a light-guide 32 for guiding light emitted by a light source 50, for example, a light emitting diode 50. The light-guide 32 further comprises light extraction means 60 for extracting light guided by the light-guide 32 out of the light-guide 32. The distribution, size and/or density of the light extraction means 60 determines the intensity and lateral dimensions L over which the light guided by the light-guide 32 is emitted. In the embodiment of the artificial skin 12 shown in Fig. 1 B again the light-guide 32 is directly applied to the translucent cover layer 20. However, again, intermediate layers may be present.

The light-guide 32 may, for example, comprise a single flexible sheet of light transmissive material through which the light of the light source 50 is guided. Alternatively, the light-guide 32 may be constituted by an arrangement of a plurality of light fibers 32, each light fiber comprises light extraction means. The plurality of light fibers 32 may, for example, be woven (see Fig. 3B) to form a plaiting-layer or interweaving-layer of light fibers 32 to form the light-emitting layer 32. In such an arrangement it may be relatively easy to produce a maze of different colors of light which may contribute to the local coloring at the location in the artificial skin 12 which requires coloring. Using different light sources 50 which may be connected to a plurality of light fibers 32, an even emission of light of each of the different light sources 50 may be obtained while still having a relatively thin and flexible light-guide32 which may relatively easily be applied as a light emitting layer 32 in the artificial skin 12.

Using a light-guide as light emitting layer has a further advantage that additional luminescent materials (not shown) may be applied to the light-guide - even locally - to alter the coloring locally to more closely match the required coloring of the artificial skin 12, or to provide a different coloring at a first location in the artificial skin 12 and a second coloring, different or slightly different from the first coloring at a second location in the artificial skin 12. A single light-guide 32 may be used to distribute the light of the light source 50 throughout the light-guide 32. A first luminescent material may absorb part of the light emitted by the light source 50 and convert part of the absorbed light into light of a first color. A second luminescent material may absorb part of the (same) light emitted by the light source 50 and convert part of the absorbed light into light of a second color, different from the first color. By locally applying the first and second luminescent materials in predefined patterns, the color of the light emitted at a specific area may be different compared to the color of the light emitted at a further area while still only a single light source is used. Alternatively even local variations may be generated by, for example, varying a specific mixture of luminescent materials to gradually alter the color emitted from the light emitting layer 32.

In the embodiment of the artificial skin 14 as shown in Fig. 1C the light emitting layer 34 is constituted by an organic light emitting diode 34. Also organic light emitting diodes may be produced to have relatively large light emitting surfaces such that the artificial skin 14 comprising this light emitting layer 14 produces a coloring of the artificial skin 14 which closely resembles a real-life coloring. In the embodiment shown in Fig. 1C an additional intermediate layer in the form of a diffuser layer 80 is applied between the organic light emitting diode 14 and the translucent cover layer 20. In the specific example of the artificial skin 14 of Fig. 1C the diffuser layer 80 is used to function as a kind of filling layer to overcome the topology difference between the organic light emitting diode 14 and the translucent cover layer 20. The controller 44 typically is configured for controlling an intensity and/or color of the light emitted from the organic light emitting diode 34.

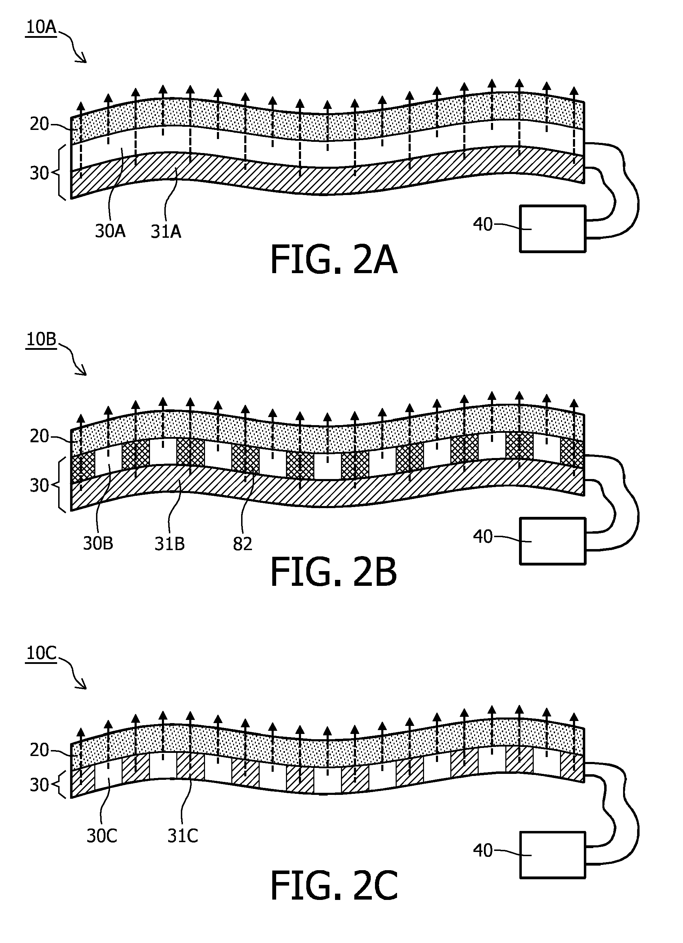

Figs. 2A to 2C are schematic cross-sectional representations of embodiments of the artificial skin 10A, 10B, 10C according to the invention in which different electroluminescent materials 30A, 30B, 30C, 31A, 31 B, 31C are used, each emitting a different color. Using different electroluminescent materials 30A, 30B, 30C, 31A, 31B, 31C different coloring may be achieved by controlling the light output from the individual electroluminescent materials 30A, 30B, 30C, 31A, 31 B, 31C, for example, via the controller 40.

In a first embodiment shown in Fig. 2A, the first electroluminescent material 30A is arranged between the second electroluminescent material 31À and the translucent cover layer 20. Light emitted from the first electroluminescent material 30A is indicated with dashed arrows emanating from the first electroluminescent material 30A and light emitted from the second electroluminescent material 31A is indicated with dash-dotted arrows emanating from the second luminescent material 31A. Preferably, the first electroluminescent material 30A is at least partially transparent to the light emitted by the second electroluminescent material 31A to allow the light of the second electroluminescent material 31 A to be emitted from the artificial skin 10A via the translucent cover layer 20. In a second embodiment shown in Fig. 2B the first electroluminescent material 30B comprises holes 82 through which the light of the second electroluminescent material 31 B is transmitted through the layer of first electroluminescent material 30B. In a third embodiment shown in Fig. 2C the first electroluminescent material 30C and the second electroluminescent material 31 D are interleaved to form the electroluminescent sheet 30. In such an embodiment the individual dimensions of separate areas of the first electroluminescent material 30C and the second electroluminescent material 31C in the interleaved electroluminescent sheet 30 is preferably such that the individual areas are not visible through the translucent cover layer 20. In the embodiment shown in Figs. 2A to 2C the light of the first electroluminescent material 30A, 30B, 30C and of the second electroluminescent material 31A, 31 B, 31C may be used at a single location in the artificial skin 10A, 10B, 10C to mix the emitted light of the different luminescent materials 30A, 30B, 30C, 31A, 31 B, 31C or to use the light of the different luminescent materials 30A, 30B, 30C, 31A, 31 B, 31C sequentially at the same location.

Figs 3A and 3B are schematic top-views of different embodiments of the light emitting layer 30, 32 for the artificial skin 10, 12 according to the invention. In the embodiments shown in Figs 3A and 3B a sensor 70 is applied which senses ambient conditions and provides the measurement signal Sm to the controller 40 such that the emission of the light emitting layer 30, 32 is adapted to the measured ambient conditions.

The embodiment shown in Fig. 3A is a top-view of the embodiment in which the light emitting layer 32 comprises a light-guide 32 already shown in Fig. 2C in which the first luminescent material 30C is interleaved with the second luminescent material 31C. The individual areas of the first luminescent material 30C and the second luminescent material 31C are preferably not visible through the translucent cover layer 20 (see Figs. 1 and 2) such that the emission of light from the first luminescent material 30C and/or from the second luminescent material 31C is perceived through the translucent cover layer 20 as a homogeneous illumination from a lateral extending surface.

The embodiment shown in Fig. 3B is a top-view of a light emitting layer 32 being a light-guide 32 which is constituted by an arrangement of a plurality of light fibers 32A, 32B, each light fiber 32A, 32B comprises light extraction means 60. Light is typically only extracted from the light fiber 32A, 32B at a location where the light extraction means 60 are present. The plurality of light fibers 32A, 32B may, for example, be woven to form a plaiting-layer 32 or interweaving-layer 32 of light fibers 32A, 32B to form the light-emitting layer 32. In the maze 32 shown in Fig. 3B different light sources 50A, 50B are used to emit different colors of light which may contribute to the local coloring at the location in the artificial skin 12 which requires coloring. The light extraction means 60 may have a lateral shape Lx, Ly substantially corresponding to a shape of an area of the human or animal skin being changeable to the predefined color. For example, when oxygen deficit occurs in a neonatal, part of the facial-area around the mouth of the neonatal changes color. To mimic this local changing of the color in the patient simulator 100 according to the invention, the light emitting layer 32 comprises a lateral shape Lx, Ly which resembles the shape of the area which changes color - in our example, the area around the mouth of the neonatal. Consequently, a substantial even coloring may be obtained around the mouth of the patient simulator 100 in which the lateral shape Lx, Ly corresponds to the shape observed in real-life coloring of the neonatal.

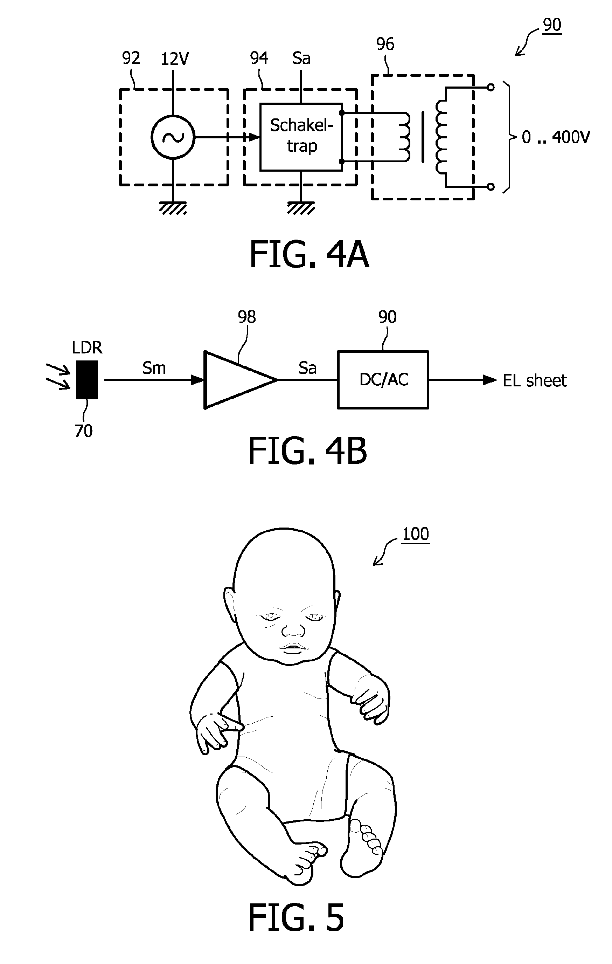

Figs, 4A and 4B are schematic electronic circuits which are used to provide regulated power to the electroluminescent sheet 30 and to amplify the sensing signal from the sensor, respectively. In Fig. 4A an AC power supply 90 is shown for the electroluminescent sheet 30 which typically requires AC-power. The artificial skin 10 may, for example, comprise the power-supply 90 for providing AC-power to the electroluminescent sheet 30. The power-supply 90 comprises an oscillator stage 92 for receiving a DC input power (12 Volts in Fig. 4A) and for generating a first power signal, and comprising an amplifying stage 94 for receiving the first power signal and for adapting the first power signal for varying an output power signal provided to the electroluminescent sheet 30. The amplifying stage 94 comprises a switching element 94 for regulating an amplitude of the first power signal. By splitting the oscillator stage 92 in the power-supply 90 from the amplifying stage 94, a power-supply 90 is provided which may provide AC-power over a relatively large range while remaining substantially stable within this range. Typically the output power signal is transformed to higher voltages via the transformer stage 96. A further advantage of this splitting of the oscillator stage 92 and the amplifying stage 94 is that a sensing signal Sa received from the sensor 70 for sensing an ambient condition may be used to control the intensity of the light emitted from the light emitting layer 30, 32, 34. The sensing signal Sa may directly be used as control-signal for controlling the amplifying stage 94 to control the output power signal, and consequently the intensity of the light emitted from the electroluminescent sheet 30. Fig. 4B is a schematic electronic circuit in which the measurement signal Sm from the sensor 70 is amplified via an additional operational amplifier 98 to generate the sensing signal Sa to the power-supply 90. The sensor 70 is an LDR which stands for Light Dependent Resistor which may be used to measure the ambient illumination conditions such that the emission of light from the electroluminescent sheet 30 may be adapted to closely imitate a real-life coloring of the artificial skin.

Fig. 5 is a schematic representation of a patient simulator 100 comprising the artificial skin 10, 12, 14 according to the invention.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements. In the device claim enumerating several means, several of these means may be embodied by one and the same item of hardware. The mere fact that certain measures are recited in mutually different dependent claims does not indicate that a combination of these measures cannot be used to advantage.

## Claims

1. An artificial skin (10, 12, 14) configured for adapting a color of the artificial skin (10, 12, 14), the artificial skin (10, 12, 14) being a layered structure comprising:
- a translucent cover layer (20) configured for imitating human or animal skin, and
- a light emitting layer (30, 32, 34) being configured for emitting light from a surface of the light emitting layer (30) through the translucent cover layer (20) for adapting the color of the artificial skin into a predefined color of the artificial skin, a lateral dimension of the light emitting layer (30, 32, 34) being configured to closely imitate a real-life coloring of the artificial skin.

2. The artificial skin (10, 12, 14) as claimed in claim 1, wherein the light emitting layer (30, 32, 34) extends substantially parallel to at least a part of the translucent cover layer (20) for substantially following an outer topography of the artificial skin (10, 12, 14).

3. The artificial skin (10, 12, 14) as claimed in claim 1 or 2, wherein the light emitting layer (30, 32, 34) comprises a lateral shape (L; Lx, Ly) substantially corresponding to a shape of an area of the human or animal skin being changeable to the predefined color.

4. The artificial skin (10, 12, 14) as claimed in claim 1, 2 or 3, wherein the light emitting layer (30, 32, 34) comprises:
- an electroluminescent sheet (30), and/or
- a organic light emitting diode device (34), and/or
- a light-guide (32) being configured for receiving light from a light source (50) and for guiding the light in a direction substantially parallel to the light emitting layer (30, 32, 34), the light guide (32) further comprises light extraction means (60) for extracting light from the light-guide (32) towards the translucent cover layer (20).

5. The artificial skin (10, 12, 14) as claimed in claim 4 in which the light emitting layer (30, 32, 34) comprises the electroluminescent sheet (30), wherein the electroluminescent sheet (30) is constituted by a first electroluminescent material (30A, 30B, 30C) emitting light of a first color and is constituted by a second electroluminescent material (31A, 31 B, 31 C) emitting light of a second color different from the first color.

6. The artificial skin (10, 12, 14) as claimed in claim 5, wherein the first electroluminescent material (30A, 30B, 30C) is arranged between the second electroluminescent material (31A, 31 B, 31 C) and the translucent cover layer (20), or wherein the first electroluminescent material (30A, 30B, 30C) and the second electroluminescent material (31A, 31 B, 31 C) are interleaved to form the electroluminescent sheet (30).

7. The artificial skin (10, 12, 14) as claimed in claim 5 or 6, wherein the artificial skin (10, 12, 14) comprises a controller (40) configured for independently control the first electroluminescent material and the second electroluminescent material.

8. The artificial skin (10, 12, 14) as claimed in claim 4 in which the light emitting layer (30, 32, 34) comprises the light-guide (32), wherein the light-guide (32) is constituted by an arrangement of a plurality of light fibers (32A, 32B), each light fiber (32A, 32B) comprises light extraction means (60).

9. The artificial skin (10, 12, 14) as claimed in claim 4 in which the light emitting layer (30, 32, 34) comprises the light-guide (32), wherein a local density and/or distribution of the light extraction means (60) is configured for generating a lateral distribution of the extracted light across a part of the translucent cover layer (20).

10. The artificial skin (10, 12, 14) as claimed in claim 1, 2 or 3, wherein the artificial skin (10, 12, 14) further comprises a sensor (70) and a controller (40), the sensor (70) being configured for sensing an ambient condition, and the controller (40) being configured for adapting the emission of light from the light emitting layer (30, 32, 34) depending on the sensed ambient condition.

11. The artificial skin (10, 12, 14) as claimed in claim 10, wherein the ambient condition comprises:
- an ambient illumination condition in which the controller (40) is configured for adapting the emission of light from the light emitting layer (30, 32, 34) in response to the sensed ambient illumination condition, the ambient illumination condition comprising an intensity of the ambient light and/or a color of the ambient light, and/or
- an ambient temperature condition in which the controller (40) is configured for adapting the emission of light from the light emitting layer (30, 32, 34) in response to the sensed ambient temperature condition.

12. The artificial skin (10, 12, 14) as claimed in claim 1, 2 or 3, wherein the artificial skin (10, 12, 14) further comprises a diffuser layer (80) arranged between the translucent cover layer (20) and the light emitting layer (30, 32, 34).

13. The artificial skin (10, 12, 14) as claimed in claim 1, 2 or 3, wherein the translucent cover layer (20) is configured for having a color being perceived as healthy when irradiated with ambient light, and wherein a color of the light emitted by the light emitting layer (30, 32, 34) is configured for generating a predefined color of the artificial skin after transmission through the translucent cover layer (20).

14. The artificial skin (10, 12, 14) as claimed in claim 4 in which the light emitting layer (30, 32, 34) comprises the electroluminescent sheet (30), wherein the artificial skin (10, 12, 14) comprises a power-supply (90) for providing AC-power to the electroluminescent sheet (30), the power-supply (90) comprising an oscillator stage (92) for receiving a DC input power (Pi) and for generating a first power signal (Pf), and comprising an amplifying stage (94) for receiving the first power signal (Pf) and for adapting the first power signal (Pf) for varying an output power signal (Po) provided to the electroluminescent sheet (30).

15. Patient simulator (100) comprising the artificial skin (10, 12, 14) as claimed in any one of the claims 1 to 14.
